# EUROPÄISCHE PATENTSCHRIFT

(11) **EP 0 541 903 B1**
(45) Veröffentlichungstag und Bekanntmachung des Hinweises auf die Patenterteilung: **23.12.1998**
(21) Anmeldenummer: 92111752.9
(22) Anmeldetag: 10.07.1992
(51) Int. Cl.: H01J 37/34, C23C 14/34

(54) **Kathode zum Beschichten eines Substrats**
Cathode for coating a substrate
Cathode pour revêtir un substrat

(30) Priorität: 14.11.1991 DE 4137483
(43) Veröffentlichungstag der Anmeldung: 19.05.1993
(73) Patentinhaber: Balzers und Leybold Deutschland Holding Aktiengesellschaft, 63450 Hanau (DE)
(72) Erfinder: Wolf, Bernd, W-6450 Hanau 1 (DE); Müller, Jürgen, Dr., W-6000 Frankfurt 50 (DE); Neudert, Hans, W-6463 Freigericht (DE)

(56) Entgegenhaltungen:
- EP-A- 163 445
- EP-A- 316 523
- EP-A- 337 012
- EP-A- 0 482 891
- US-A- 4 500 409

## Beschreibung

Die Erfindung betrifft eine Kathode für ein System zum Beschichten eines Substrats, bei dem die Kathode an eine Gleichstrom-und/oder Wechselstromquelle (Hochfrequenzquelle) angeschlossen und in einer evakuierbaren Beschichtungskammer angeordnet ist und die Kathode elektrisch mit einem Target in Verbindung steht, das zerstäubt wird und dessen zerstäubte Teilchen sich auf dem Substrat niederschlagen, wobei in die Beschichtungskammer ein Prozeßgas einbringbar ist und die Kathode aus einem im wesentlichen topfförmigen Gehäuse gebildet ist, dessen geschlossenes Bodenteil mit seiner Außenfläche mit dem Target fest verbunden ist und dessen dem Target abgewandtes, offenes Ende mit Hilfe eines Flansches in einer Öffnung in der Außenwand der Beschichtungskammer abgedichtet so gehalten ist, daß der Innenraum des Gehäuses stets dem Atmosphärendruck ausgesetzt ist und die einen Teil der Innenfläche der Beschichtungskammer bildende, nicht mit dem Target verbundene Außenfläche des mit dem Target verbundenen, in die Beschichtungskammer hineinragenden, hülsenförmigen Teils des im wesentlichen topfförmigen Gehäuses vom in der Beschichtungskammer jeweils herrschenden Druck beaufschlagt ist.

Bekannt ist eine Zerstäubungskathode nach dem Magnetronprinzip (EP-A-0 337 012) mit einem aus mindestens einem Teil bestehenden Target, mit einem hinter dem Target angeordnete Magnetsystem, mit mehreren ineinanderliegenden und in sich geschlossenen Magneteinheiten abwechselnd unterschiedlicher Polung, durch die mindestens zwei gleichfalls in sich geschlossene, ineinanderliegende magnetische Tunnels aus bogenförmig gekrümmten Feldlinien gebildet werden, wobei die dem Target abgekehrten Pole der Magneteinheiten über ein Magnetjoch miteinander verbunden sind und wobei die magnetische Feldstärke mindestens eines Magnetfeldes relativ zu der magnetischen Feldstärke mindestens eines weiteren Magnetfeldes über ein verschieben eines der Jochteile zum Target über eine Verstelleinrichtung veränderbar ist, wobei die Verstelleinrichtung über einen elektrischen Schaltkreis ansteuerbar ist, der mit mindestens einem optischen Sensor zusammenwirkt, der auf mindestens einen der sich beim Beschichtungsvorgang einstellenden Plasmaringe ausgerichtet ist und auf die Helligkeit dieses Plasmaringes anspricht.

Diese vorbekannte Zerstäubungskathode weist bereits einen topfförmigen Grundkörper auf, der in eine Öffnung in der Wand der Beschichtungskammer eingesetzt ist, der jedoch insgesamt sehr flach gestaltet ist und nur das Magnetjoch umschließt und gegenüber dem Kammergehäuse elektrisch isoliert ist.

Der vorliegenden Erfindung liegt die Aufgabe zugrunde, eine Sputterkathode zu schaffen, die so in bzw. an der Beschichtungskammer angeordnet werden kann, daß ihre Magnetanordnung auch dann zugänglich ist, also beispielsweise austauschbar ist, wenn die Beschichtungskammer evakuiert ist, deren Kühleinrichtung so beschaffen ist, daß im Falle einer Leckage im Kühlsystem kein Kühlmittel in die Beschichtungskammer eindringen kann, deren Platzbedarf im Vergleich zu herkömmlichen Kathoden besonders gering ist, deren Magnetanordnung auch während des Beschichtungsprozesses in ihrem Abstand zum Target verstellbar ist, die auch für einen Ultra-Hochvakuumprozeß bei Temperaturen von etwa 200°C bis 400°C betrieben werden kann und deren Kühlsystem so gestaltet ist, daß die Kühlkanäle und Kühlkammern durchweg im Bereich des Außenmantels vorgesehen sind und so eine optimale Kühlleistung ermöglichen.

Diese Aufgabe wird erfindungsgemäß gelöst durch einen im topfförmigen Gehäuse gehaltenen, ebenfalls im wesentlichen topfförmigen Einsatz, der mit sich quer zur Gehäuselängsachse erstreckenden Bohrungen versehen ist, die zum einen der Halterung und Führung von elektrischen Kontaktbolzen, deren radial äußere Enden jeweils an der Innenwand des Gehäuses anliegen und deren gegenüberliegende Enden jeweils mit elektrischen Leitern (52,53) verbunden sind, dienen und zum anderen zumindest Abschnitte von Kühlkanälen bilden, die einerseits mit Anschlußstutzen am Einsatz und andererseits mit im topfförmigen Gehäuse vorgesehenen Hohlräumen korrespondieren, wobei der Einsatz aus einem elektrisch isolierenden Werkstoff, beispielsweise aus Keramik, gefertigt ist und ein Magnetjoch im Innenraum zwischen dem Einsatz und dem Bodenteil des im wesentlichen topfförmigen Gehäuses im Abstand vom Target verstellbar hält.

Weitere Merkmale und Einzelheiten sind in den Patentansprüchen näher beschrieben und gekennzeichnet.

Die Erfindung läßt die verschiedensten Ausführungsmöglichkeiten zu; eine davon ist in den anhängenden Zeichnungen schematisch näher dargestellt, und zwar zeigen:
- Figur 1: den Längsschnitt durch die Sputterkathode mit angeschraubtem Target und durch eine Ebene (Schnitt C-C gemäß Figur 4), die die Kühlkanäle und die Kühlmittelanschlüsse zeigt,
- Figur 2: einen weiteren Längsschnitt durch die Kathode nach Figur 1, jedoch entlang einer zweiten Ebene (Schnitt D-D gemäß Figur 4),
- Figur 3: einen weiteren Längsschnitt entlang einer dritten Ebene (Schnitt E-E gemäß Figur 4) und
- Figur 4: die Draufsicht auf die Kathode gemäß den Figuren 1 bis 3.

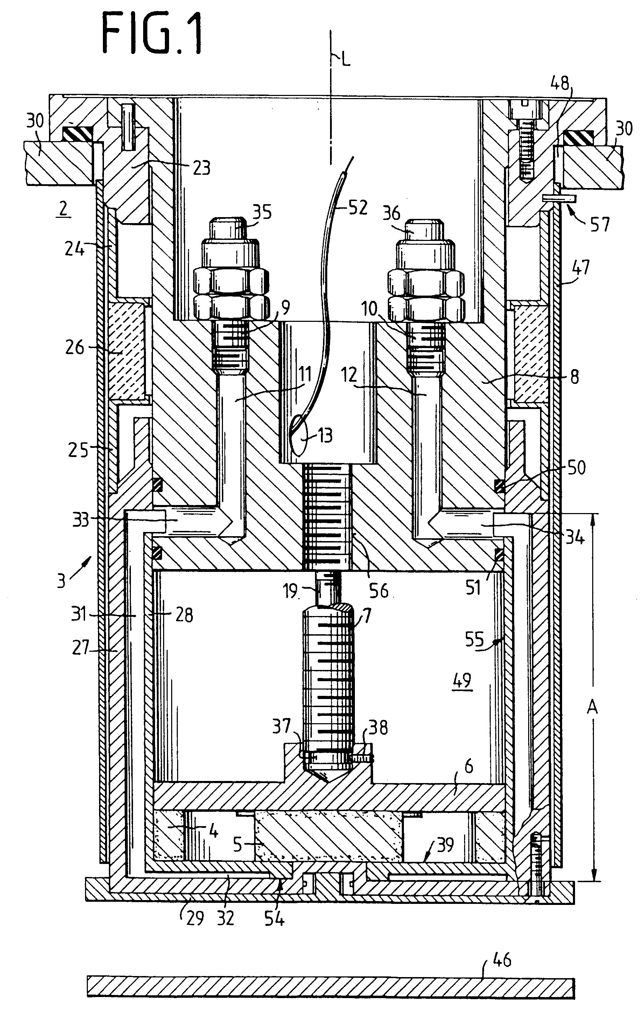

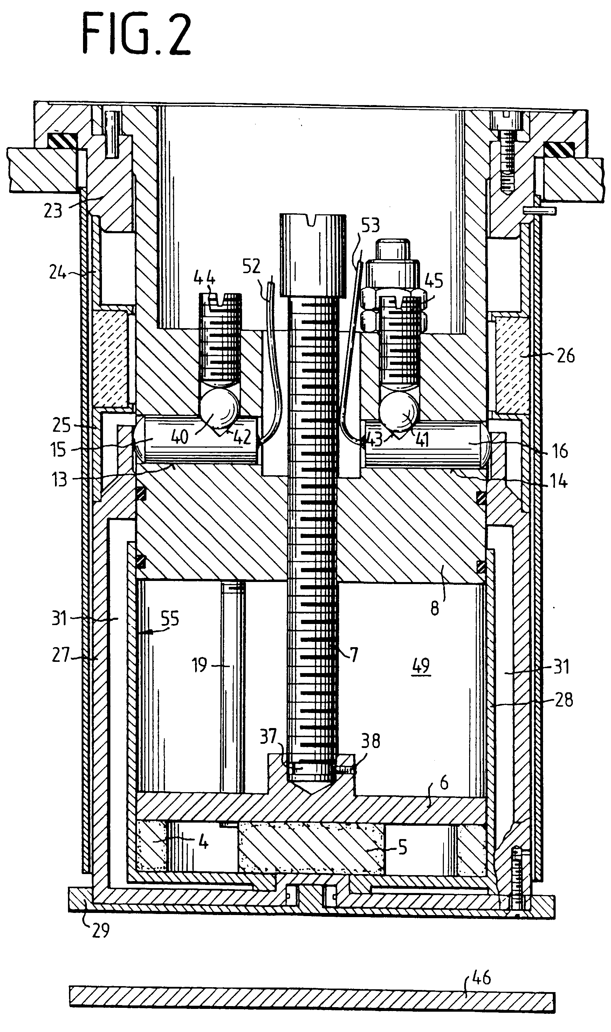

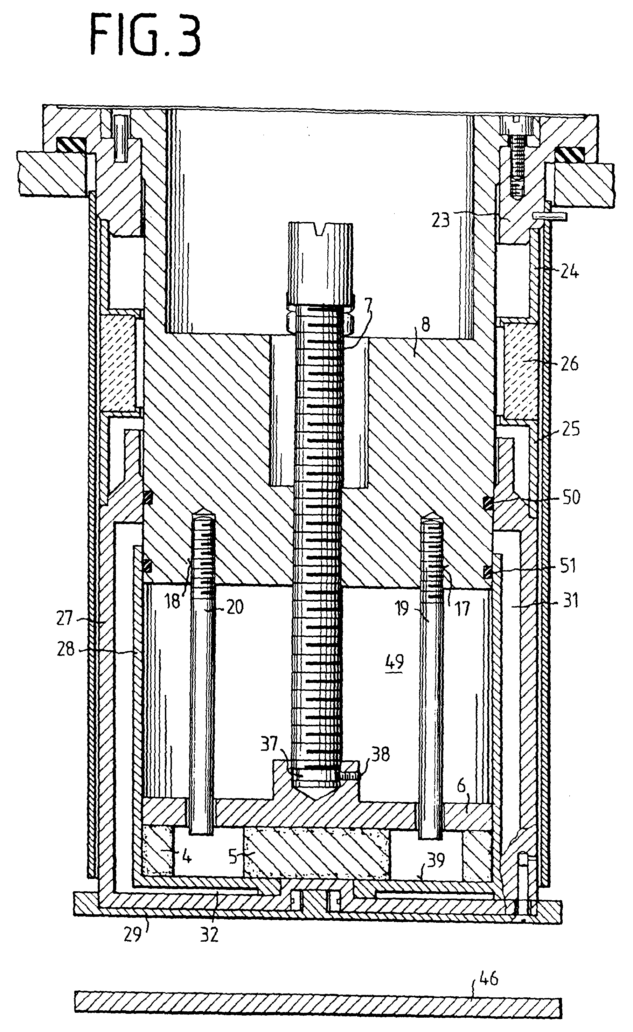

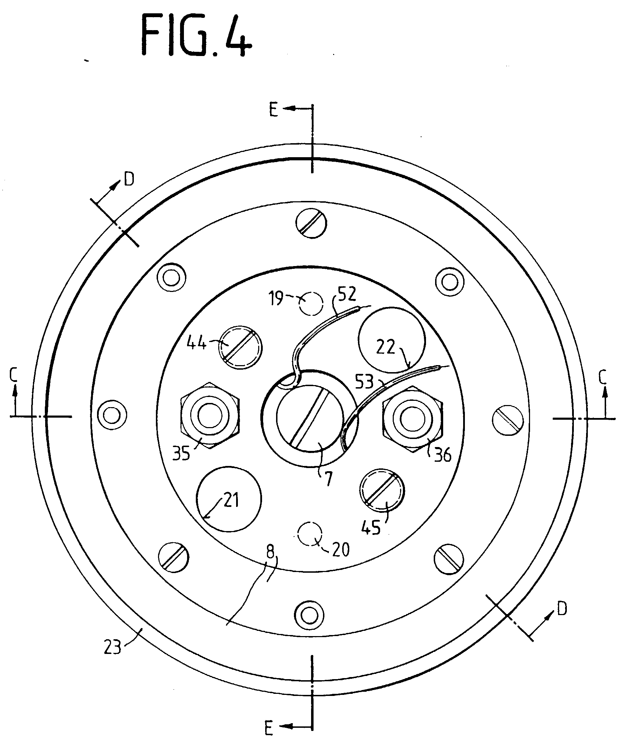

Die Kathode besteht im wesentlichen aus einem topfförmigen, aus mehreren Teilen gebildeten Gehäuse 3, zwei im Boden des topfförmigen Gehäuses 3 gehaltenen Permanentmagneten 4, 5 mit einem kreisscheibenförmigen Magnetjoch 6 und einer Hubspindel 7, die in das starkwandige Bodenteil eines ebenfalls topfförmigen Einsatzes 8 eingeschraubt ist (Figur 1) und das die Anschlußstutzen 9, 10 für die Kühlkanäle 11, 12, die Bohrungen 13, 14 für die elektrischen Kontaktbolzen 15, 16 (Figur 2), die Gewindebohrungen 17, 18 für die beiden Führungsstäbe 19, 20 (Figur 3) und schließlich die beiden Öffnungen 21, 22 (Figur 4) für die Anschlußkabel eines Elektromagneten enthält (der nicht näher dargestellt ist).

Das topfförmige Gehäuse 3 besteht aus einem Flansch 23 zur Halterung der Kathode an der Wand 30 der Prozeßkammer, den beiden Profilringen 24, 25, dem zwischen den beiden Profilringen 24, 25 angeordneten Keramikring 26, dem äußeren Hülsenteil 27 und dem inneren Hülsenteil 28 und dem Target 29.

Wie aus Figur 1 ersichtlich; sind die beiden Hülsenteile 27, 28 so konzentrisch zueinander angeordnet und so bemessen, daß ein kreisringzylindrischer Hohlraum 31 von ihnen gebildet wird und ebenso ein etwa kreisscheibenförmiger Hohlraum 32 im Bereich des mit dem Target 29 verbundenen Bodens 39 des Gehäuses 3. Diese Hohlräume 31 und 32 korrespondieren mit Anschlußbohrungen 33 bzw. 34, die im Einsatz 8 vorgesehen sind und die wiederum mit den Kühlkanälen 11, 12 verbunden sind, die ihrerseits über die Verschraubungen oder Stutzen 9, 10 an die Kühlmittelleitung 35, 36 angeschlossen sind.

Figur 3 zeigt, daß das Magnetjoch 6 mit dem unteren Ende der Hubspindel 7 über einen in eine Ringnut 37 eingreifenden, im Joch 6 festgehaltenen Stift 38 verbunden ist, derart, daß beim Drehen der Hubspindel 7 das Joch 6 - je nach Drehrichtung - auf- oder abwärts bewegt werden kann, wobei gleichzeitig das Joch 6 mit Hilfe der mit dem Einsatz 8 fest verschraubten Führungsstäbe 19, 20 an einer Mitdrehung gehindert ist. Durch ein Anheben oder Absenken des Magnetjochs 6 und der mit diesem fest verbundenen Permanentmagnete 4, 5 können in an sich bekannter Weise die Parameter des Beschichtungsprozesses beeinflußt werden.

Die in Figur 4 erkennbaren Öffnungen 21, 22 ermöglichen - was im einzelnen nicht näher dargestellt ist - den Einbau eines Elektromagneten anstelle der Permanentmagnete 4, 5 mit ihrem zugehörigen Magnetjoch 6. In diesem Falle werden das Joch 6 mit seinen auf ihm befestigten Magneten 4, 5, die Hubspindel 7 und die Führungsstäbe 19, 20 ausgebaut, um dann anschließend einen Elektromagneten mit vorzugsweise kreiszylindrischer Konfiguration in den Raum 49 zwischen dem Einsatz 8 und dem Bodenteil 39 des Gehäuses 3 einsetzen zu können. Die Öffnungen 21, 22 im Einsatz 8 dienen in diesem Falle als Durchführung für die Stromzuleitungen des Elektromagneten.

Die vorstehend beschriebene Kathode hat den Vorteil, daß sich der Kühlmantel bzw. die vom Kühlmittel durchflossenen Hohlräume 31, 32 außen befinden, während die Kühlmittelanschlüsse 9, 10 innen sind, so daß eine Leckage in der Kühlmittelzuleitung nicht zu einem Kühlmitteleinbruch in die Prozeßkammer 2 führen kann. Die Kühlmittelanschlüsse können auch ohne weiteres von den Verschraubungen bzw. den Anschlußstutzen 9, 10 gelöst werden, ohne daß die Prozeßkammer 2 belüftet werden muß.

Darüber hinaus können die Magnetsätze bei evakuierter Prozeßkammer ausgetauscht werden, und es kann der Abstand zwischen den Magneten und dem Target 29 verändert werden, ohne daß die Prozeßkammer 2 geöffnet werden muß. Zum Aufheizen einer UHV-Version der Kathode läßt sich auch der Einsatz 8 und der an diesem befestigte Magnetsatz 4, 5, 6 einfach nach hinten bzw. oben zu aus der Kathode entfernen.

Es sei noch erwähnt, daß die Stromzuführung 52, 53 zu den Hülsenteilen 27, 28 bzw. zum Target 29 über die aus Figur 2 ersichtlichen Kontaktbolzen 15, 16 erfolgt, die mit Hilfe von Kugeln 40, 41, die in Kerben 42, 43 eingreifen und die an Spannschrauben 44, 45 anliegen bzw. von diesen unter Vorspannung gehalten werden, nach außen gedrückt werden. Durch festes Anziehen der Spannschrauben 44, 45 werden die Bolzen 15, 16 so weit radial nach außen gedrückt, daß ein sicherer Stromübergang zwischen den Kontaktbolzen 15, 16 und der Hülse 27 gewährleistet ist.

Der Einsatz 8 ist schließlich mit Hilfe von Rundschnurringen (Dichtringen) 50, 51 so gegenüber der Innenwand des Gehäuses 3 abgedichtet, daß das Kühlmittel nur von den Anschlußbohrungen 33, 34 aus in den Hohlraum bzw. Zwischenraum 31 eintreten kann. Die innere Hülse 28 ist zu diesem Zweck im Bereich des Bodenteils 39 bei 54 fest mit der äußeren Hülse 27 verbunden, beispielsweise verschweißt, so daß bei einer Undichtigkeit im Bereich der Dichtungen 50, 51 kein Kühlmittel in die Beschichtungskammer 2 eindringen kann.

### Bezugszeichenliste

- 2: Beschichtungskammer
- 3: Gehäuse
- 4: Permanentmagnet
- 5: Permanentmagnet
- 6: Magnetjoch
- 7: Hubspindel
- 8: Einsatz
- 9: Anschlußstutzen
- 10: Anschlußstutzen
- 11: Kühlkanal
- 12: Kühlkanal
- 13: Bohrung
- 14: Bohrung
- 15: Kontaktbolzen
- 16: Kontaktbolzen
- 17: Gewindebohrung
- 18: Gewindebohrung
- 19: Führungsstab
- 20: Führungsstab
- 21: Öffnung
- 22: Öffnung
- 23: Flansch
- 24: Profilring
- 25: Profilring
- 26: ringförmiges Zwischenstück, Isolierring
- 27: Hülsenteil (außen)
- 28: Hülsenteil (innen)
- 29: Target
- 30: Wand der Prozeßkammer
- 31: kreisringzylindrischer Hohlraum (Ringraum)
- 32: kreisscheibenförmiger Hohlraum (Ringraum)
- 33: Anschlußbohrung
- 34: Anschlußbohrung
- 35: Kühlmittelleitung
- 36: Kühlmittelleitung
- 37: Ringnut
- 38: Stift
- 39: Gehäusebodenteil
- 40: Kugel
- 41: Kugel
- 42: Kerbe
- 43: Kerbe
- 44: Spannschrauben
- 45: Spannschrauben
- 46: Substrat
- 47: Dunkelraumabschirmung
- 48: Öffnung
- 49: Innenraum
- 50: Ringdichtung
- 51: Ringdichtung
- 52: elektrischer Leiter
- 53: elektrischer Leiter
- 54: Verbindungsstelle
- 55: Gehäuseinnenwand
- 56: Gewindebohrung
- 57: Renkverbindung

## Patentansprüche

1. Kathode für ein System zum Beschichten eines Substrats (46), bei dem die Kathode an eine Gleichstrom- und/oder Wechselstromquelle (Hochfrequenzquelle) angeschlossen und in einer evakuierbaren Beschichtungskammer (2) angeordnet ist und die Kathode elektrisch mit einem Target (29) in Verbindung steht, das zerstäubt wird und dessen zerstäubte Teilchen sich auf dem Substrat (46) niederschlagen, wobei in die Beschichtungskammer (2) ein Prozeßgas einbringbar ist und die Kathode aus einem im wesentlichen topfförmigen Gehäuse (3) gebildet ist, dessen geschlossenes Bodenteil (39) mit seiner Außenfläche mit dem Target (29) fest verbunden ist und dessen dem Target (29) abgewandtes, offenes Ende mit Hilfe eines Flansches (23) in einer Öffnung (48) in der Außenwand (30) der Beschichtungskammer (2) abgedichtet so gehalten ist, daß der Innenraum (49) des Gehäuses (3) stets dem Atmosphärendruck ausgesetzt ist und die einen Teil der Innenfläche der Beschichtungskammer (2) bildende, nicht mit dem Target (29) verbundene Außenfläche des mit dem Target (29) verbundenen, in die Beschichtungskammer (2) hineinragenden, hülsenförmigen Teils des im wesentlichen topfförmigen Gehäuses (3) vom in der Beschichtungskammer (2) jeweils herrschenden Druck beaufschlagt ist, **gekennzeichnet durch** einen im topfförmigen Gehäuse (3) gehaltenen, ebenfalls im wesentlichen topfförmigen Einsatz (8), der mit sich quer zur Gehäuselängsachse erstreckenden Bohrungen (13,14 bzw. 33,34) versehen ist, die zum einen der Halterung und Führung von elektrischen Kontaktbolzen (15,16), deren radial äußere Enden jeweils an der Innenwand (55) des Gehäuses (3) anliegen und deren gegenüberliegende Enden jeweils mit elektrischen Leitern (52,53) verbunden sind, dienen und zum anderen zumindest Abschnitte von Kühlkanälen (33,34) bilden, die einerseits mit Anschlußstutzen (9,10) am Einsatz (8) und andererseits mit im topfförmigen Gehäuse (3) vorgesehenen Hohlräumen (31,32) korrespondieren, wobei der Einsatz (8) aus einem elektrisch isolierenden Werkstoff, beispielsweise aus Keramik, gefertigt ist und ein Magnetjoch (6) im Innenraum (49) zwischen dem Einsatz (8) und dem Bodenteil des im wesentlichen topfförmigen Gehäuses im Abstand zum Target verstellbar hält.

2. Kathode nach Anspruch 1, **dadurch gekennzeichnet,** daß das topfförmige Gehäuse (3) aus dem Flansch (23) und einem Hülsenteil (27) gebildet ist, die beide durch ein ringförmiges, von zwei Profilringen (24,25) gehaltenes Zwischenstück (26) aus einem elektrisch isolierenden Werkstoff miteinander verbunden sind, wobei der auf der dem Target (29) abgekehrten Ende angeordnete Flansch (23) einerseits mit der Prozeßkammerwand (30) und andererseits mit dem in einem vom Hülsenteil (27) gehaltenen Einsatz (8) verbunden ist.

3. Kathode nach den Ansprüchen 1 und 2, **dadurch gekennzeichnet,** daß das topfförmige Gehäuse (3) zumindest abschnittsweise (Abschnitt A) doppelwandig ausgebildet ist, wobei der von den Wandteilen (27,28) gebildete Hohlraum (31,32) mit den Anschlußstutzen (9, 10) des Einsatzes (8) verbunden ist, der mit seiner radialen Außenwand an die Innenwand des Innenraums (49) angepaßt ist und gegenüber dieser mit Hilfe von Ringdichtungen (50, 51) abgedichtet ist.

4. Kathode nach den Ansprüchen 1 bis 3, **dadurch gekennzeichnet**, daß die Kühlkanäle (33,34) von sich quer und sich parallel zur Längsachse erstreckenden Bohrungen (33,34 bzw. 11,12) gebildet sind, die mit Schläuchen oder Rohren (35,36) korrespondieren, über die das Kühlmittel der Kathode zu- oder abgeführt wird, wobei der Einsatz (8) außerdem mit einer Gewindebohrung (56) in Gehäuselängsrichtung versehen ist, mit der eine Hubspindel (7) zusammenwirkt, deren targetseitiges Ende mit dem Joch (6) eines Satzes von Permanentmagneten (4,5) verbunden ist und über die das Joch (6) in die Gehäuselängsrichtung verschiebbar ist.

5. Kathode nach einem oder mehreren der vorhergehenden Ansprüche, **dadurch gekennzeichnet**, daß der mit der Wand (30) der Beschichtungskammer (2) verbundene Flansch (23) des Gehäuses (3) mit einer rohrförmigen Dunkelfeldabschirmung (47), beispielsweise über eine Renkverbindung (57) lösbar verbunden ist.

## Claims

1. A cathode for a system for coating a substrate (46) wherein the cathode is connected to a d.c.- and/or a.c. source (high-frequency source) and is arranged in an evacuatable coating chamber (2) and the cathode is electrically connected to a target (29) which is sputtered and the sputtered particles of which are precipitated on the substrate (46), wherein a process gas can be introduced into the coating chamber (2) and the cathode is formed by a substantially cup-shaped housing (3) whose closed base member (39) is permanently connected by its outer surface to the target (29) and whose open end facing the target (29) is held in sealed manner by means of a flange (23) in an opening (48) in the outer wall (30) of the coating chamber (2), such that the interior (49) of the chamber (3) is always exposed to the atmospheric pressure and the outer surface, forming a part of the inner surface of the coating chamber (2) and not connected to the target (29), of the sleeve-like member, connected to the target (29) and projecting into the coating chamber (2), of the substantially cup-shaped housing (3) is acted upon by the pressure in each case prevailing in the coating chamber (2), characterised by an insert (8) which is held in the cup-shaped housing (3) and is itself likewise substantially cup-shaped and is provided with bores (13, 14 and 33, 34) which extend transversely to the longitudinal axis of the housing and which on the one hand serve to retain and guide electric contact bolts (15, 16) whose radially outer ends in each case bear against the inner wall (55) of the housing (3) and whose opposite ends are in each case connected to electric conductors (52, 53), and on the other hand at least form portions of cooling channels (33, 34) which on one side correspond with tubular connectors (9, 10) on the insert (8) and on the other side with cavities (31, 32) provided in the cup-shaped housing (3), said insert (8) being produced from an electrically insulating material, for example ceramic, and retaining a magnet yoke (6) in the inner space (49) between the insert (8) and the base member of the substantially cup-shaped housing so as to be adjustable in respect of its distance from the target.

2. A cathode according to Claim 1, characterised in that the cup-shaped housing is formed by the flange (23) and a sleeve member (27), both of which are connected to one another by a ring-shaped adaptor (26) consisting of an electrically insulating material and held by two profiled rings (24, 25), where the flange (23) arranged on the end facing away from the target (29) is connected on the one hand to the process chamber wall (30) and on the other hand to the insert (8) held by the sleeve member (27).

3. A cathode according to Claims 1 and 2, characterised in that at least a portion (portion A) of the cup-shaped housing (3) is double-walled, the cavity (31, 32) formed by the wall components (27, 28) being connected to the tubular connectors (9, 10) of the insert (8), the inner wall of which is adapted to the inner wall of the interior (49) and which is sealed therefrom by sealing rings (50, 51).

4. A cathode according to Claims 1 to 3, characterised in that the cooling channels (33, 34) are formed by bores (33, 34 and 11, 12) which extend transversely and in parallel to the longitudinal axis and which correspond with hoses or tubes (35, 36) via which the coolant is supplied to or from the cathode, said insert (8) also being provided with a threaded bore (56) which extends in the longitudinal direction of the housing and cooperates with a lifting spindle (7) whose target end is connected to the yoke (6) of an assembly of permanent magnets (4, 5) and via which the yoke (6) is displaceable in the longitudinal direction of the housing.

5. A cathode according to one or more of the preceding claims, characterised in that the flange (23) of the housing (3) connected to the wall (30) of the coating chamber (2) is detachably connected to a tubular dark space screen (47), for example via a bayonet connection (57).

## Revendications

1. Cathode pour un système de revêtement d'un substrat (46), dans le cas duquel la cathode est reliée à une sourcc de courant continu et/ou de courant alternatif (source à hautc fréquence) et est disposée dans une chambre de revêtement (2) dans laquelle on peut faire le vide et dans le cas duquel la cathode est électriquement reliée à une cible (29) qui se pulvérise et dont les particules pulvérisées précipitent sur le substrat (46), dans le cas duquel on peut amener un gaz de processus dans la chambre de revêtement (2) et la cathode est formée d'un carter (3), sensiblement en forme de boisseau, dont la partie de fond (39), fermée, est solidairement reliée, par sa surface extérieure, avec la cible (29) et dont l'extrémité ouverte, située du côté opposée à la cible (29), est, à l'aide d'un rebord (23), maintenue, de façon étanche, dans une ouverture (48) prévue dans la paroi extérieure (30) de la chambre de revêtement (2) de façon que la chambre intérieure (49) du carter (3) soit toujours exposée à la pression atmosphérique et que la surface extérieure, formant une partie de la surface intérieure de la chambre de revêtement (2) et non reliée à la cible (29), de la partie en forme de douille, reliée à la cible (29) et pénétrant dans la chambre de revêtement (2), du carter (3) sensiblement en forme de boisseau (3) soit sous contrainte de la pression régnant chaque fois dans la chambre de revêtement (2), caractérisée par unc garniture insérée (8), maintenue dans le carter (3) en forme de boisseau et également sensiblement en forme de boisseau, et présentant des perçages (13, 14 ou 33, 34) qui s'étendent perpendiculairement à l'axe longitudinal du carter, qui d'une part servent à maintenir et à guider des goupilles de contact électrique (15, 16) dont les extrémités radialement extérieures s'appuient chacune contre la paroi intérieure (55) du carter (3) et dont les extrémités opposées sont chacune reliées à des conducteurs électriques (52, 53) ct d'autre part, forment au moins des tronçons de canaux de refroidissement (33, 34) qui correspondent d'une part avec des tubulures de raccordement (9, 10) prévues sur la garniture insérée (8) et d'autre part, avec des espaces creux (31,32) prévus dans le carter en forme de boisseau (3), la garniture insérée (8) étant fabriquée en un matériau électriquement isolant, par exemple en céramique, et maintenant, à une distance réglable de la cible, une culasse magnétique (6) dans la chambre intérieure (49) existant entre la garniture insérée (8) et la partie de fond du carter sensiblement en forme de boisseau, dont la distance à la cible est réglable.

2. Cathode selon la revendication 1, caractérisée par le fait que le carter en forme de boisseau (3) est formé du rebord (3) et d'une partie formant douille (27), que les deux sont réunis l'un à l'autre par une pièce intermédiaire annulaire (26), maintenue par deux profilés annulaires (24, 25) et constituée d'un matériau électriquement isolant, le rebord (23) disposé à l'extrémité opposée à la cible (29) étant relié d'une part à la paroi (30) de la chambre de processus et d'autre part à la garniture insérée (8) maintenue par la partie formant douille (27).

3. Cathode selon les revendications 1 ct 2, caractérisée par le fait que le carter en forme de boisseau (3) est prévu, au moins par tronçon (tronçon A), à double paroi, l'espace crcux (31, 32) formé par les parties de paroi (27, 28) étant reliée avec les tubulures de raccordement (9, 10) de la garniture insérée (8) qui, par sa paroi radialement extérieure, s'adapte contre la paroi intérieure de la chambre intérieure (49) et étant rendue étanche à l'égard de celle-ci à l'aide de garnitures d'étanchéité annulaires (50, 51).

4. Cathode selon les revendications 1 à 3, caractérisée par le fait que les canaux de refroidissement (33, 34) sont formés par des perçages (33, 34 ou 11, 12) qui s'étendent perpendiculairement et parallèlement à l'axe longitudinal et qui correspondent à des tuyaux souples ou à des tubes (35, 36) par lesquels un agent de refroidissement est amené à la cathode ou en est évacué, la garniture insérée (8) étant munie, selon la direction longitudinale du carter. d'un perçage taraudé (56) avec lequel collabore une tige filetée de levée dont l'extrémité, située du côté de la cible, est reliée à la culasse (6) d'un jeu d'aimants permanents (4, 5) et au moyen de laquelle on peut faire coulisser la culasse (6) selon la direction longitudinale du carter.

5. Cathode selon l'une ou plusieurs des revendications précédentes, caractérisée par le fait que le rebord (23), relié à la paroi (30) de la chambre de revêtement (2), du carter (3) est relié, de façon amovible, à un écran tubulaire à fond sombre (47), par exemple par l'intermédiaire d'une liaison à baïonnette (57).
